# EUROPEAN PATENT APPLICATION

(11) **EP 4 391 058 A1**
(43) Date of publication of application: **26.06.2024**
(21) Application number: 23215490.6
(22) Date of filing: 11.12.2023
(51) Int. Cl.: H01L 27/02, H01L 21/8234, H01L 27/118

(54) **TRANSISTOR CELL**

(30) Priority: 22.12.2022 FR 2214265
(71) Applicant: STMicroelectronics International N.V., 1228 Plan-les-Ouates, Geneva (CH)
(72) Inventor: WEBER, Olivier, 38000 GRENOBLE (FR); GUPTA, Rohit Kumar, 201306 NOIDA, UTTAR PRADESH (IN); VANDENBOSSCHE, Eric, 38920 CROLLES (FR)
(74) Representative: Thibon, Laurent

(57) **Abstract**

The present disclosure relates to an electronic device comprising at least one transistor cell (300), each cell comprising:
- a first active area (311) of at least one transistor among the transistors of said cell;
- a first insulating region (341) forming a first insulation of the first active area;
- a first insulating gate (333) extending above the first active area, forming a second insulation of the first active area; and
- a first insulating gate contact (335) coupled to the first insulating gate and adapted to coupling said first insulating gate to a power supply rail (351), said first insulating gate contact being positioned above, and straddling between, the first active area and the first insulating region.

## Description

This application claims the priority benefit of French patent application number 2214265, filed on December 12, 2022, entitled "Cellule de transistors" which is hereby incorporated by reference to the maximum extent allowable by law.

### Technical background

The present disclosure generally concerns the field of microelectronics, and in particular transistors, as well as cells comprising a plurality of transistors. The present disclosure also concerns integrated circuits comprising transistor cells.

The present disclosure also concerns pre-characterized cells, better known as "standard cells", such as those used for the design of integrated circuits.

### Prior art

In the field of microelectronics, there exists a so-called "pre-characterized cell" or "standard cell" methodology, which is a method of design of integrated circuits, particularly of application specific integrated circuits, or "ASIC".

A standard cell can be defined to integrate a plurality of transistors, with interconnection circuits, to provide, for example, a Boolean logic function (for example, the AND, OR, XOR, XNOR, or inverter functions), or a storage function (for example, flip-flop or latch).

An integrated circuit may be designed by using one or a plurality of standard cells of a library, for example allowing the repeated use of standard cells in the integrated circuit. For example, the designer of an integrated circuit desiring to integrate a variety of functions in the integrated circuit may use, in the design phase, a library of known functions, and select elements of the library, or standard cells, which contain preconfigured elements, such as transistors with interconnection circuits. The layout generated in the design phase can then be implemented in a phase of manufacturing of the integrated circuit, which can thus comprise a plurality of transistor cells.

A transistor cell may be manufactured by a CMOS, for "Complementary Metal Oxide Semiconductor", technology and comprise a plurality of "MOSFET", for "Metal Oxide Semiconductor Field Effect Transistor", transistors. These transistors can also be referred to as MOS transistors. Typically, a transistor cell may comprise at least one NMOS transistor and at least one PMOS transistor located inside, and on top of, a substrate of silicon-on-insulator type, or SOI substrate. An NMOS transistor is an N-channel MOS transistor, that is, a transistor having N-type doped source and drain regions. A PMOS transistor is a P-channel MOS transistor, that is, a transistor having P-type doped source and drain regions.

An integrated circuit may comprise a plurality of transistor cells insulated from one another, for example, by means of insulating trenches, of STI (Shallow Trench Isolation) type.

A disadvantage is that, for transistors of same size of type N and P formed according to a CMOS technology, PMOS transistors may have a lower performance than NMOS transistors, which may be attempted to be compensated for by increasing the size of the PMOS transistors, or even the doping concentrations of the PMOS transistors. An alternative is to form, in a PMOS transistor, a strained channel region, for example, with a silicon-germanium channel region (SiGe). A transistor with a strained channel region, or strained transistor, is a field-effect transistor where a channel-forming semiconductor region is mechanically strained. The presence of strain in the channel-forming region enables to increase the rapidity of the transistor, by particularly increasing the mobility of holes for a PMOS-type transistor.

Further, when PMOS transistors have a strained channel region, and when a plurality of cells are desired to be integrated in a same integrated circuit, it is preferably not to insulate the channel regions of these PMOS transistors from one another by insulating trenches, since this may have the disadvantage of releasing the strain in the channel region. A solution is to form continuous active regions between the different PMOS transistors, and to insulate adjacent cells with non-active gates, or insulating gates ("gate tie" or "tying gate"). To fulfill this insulation function, the insulating gates are biased to power supply voltage Vdd. However, these insulation gates induce other drawbacks.

### Summary of the invention

There is a need to improve transistor cells, particularly cells comprising PMOS transistors with a strained channel region.

An embodiment overcomes all or part of the disadvantages of known transistor cells.

One embodiment provides an electronic device comprising at least one cell of transistors, each cell comprising:
- a first active area of at least one transistor among the transistors of said cell;
- a first insulating region forming a first insulation of the first active area;
- a first insulating gate extending above the first active area, forming a second insulation of the first active area; and
- a first insulating gate contact coupled to the first insulating gate and adapted to coupling said first insulating gate to a power supply rail, said first insulating gate contact being positioned above, and straddling between, the first active area and the first insulating region.

One embodiment provides a non-transitory memory configured to store a cell library, each cell being defined so as to comprise:
- a first active area of at least one transistor among transistors of said cell;
- a first insulating region forming a first insulation of the first active area;
- a first insulating gate extending above the first active area, forming a second insulation of the first active area; and
- a first insulating gate contact coupled to the first insulating gate and adapted to coupling said first insulating gate to a power supply rail, said first insulating gate contact being positioned above, and straddling between, the first active area and the first insulating region.

In an embodiment, each cell further comprises:
- a second insulating gate extending above the first active area, forming a third insulation of the first active area; and
- a second insulating gate contact coupled to the second insulating gate and adapted to coupling said second insulating gate to the power supply rail, said second insulating gate contact being positioned above and straddling between the first active area and the first insulating region, the second insulating gate being for example substantially parallel to the first insulating gate.

In an embodiment, the first and/or the second insulating gate contact is intentionally in straddling position between the first active area and the first insulating region.

In an embodiment, the first and/or second insulating gate contact is centered with respect to an intermediate area between the first insulating region and the first active area.

In an embodiment, the first and/or the second isolation gate contact has a first surface area positioned above the first active area and a second surface area positioned above the first isolation region, the ratio between the first surface area and the second surface area, or between the second surface area and the first surface area, being between 0.2 and 0.8, for example between 0.25 and 0.75, for example between 0.35 and 0.65.

In an embodiment, the first and/or the second insulating gate contact has a first surface area positioned above the first active area and a second surface area positioned above the first insulating region, the first surface area being greater than the second surface area.

In an embodiment, each cell further comprises a first transistor gate extending above the first active area between a first source region and a first drain region of said first active area, said first transistor gate being for example substantially parallel to the first insulating gate.

In an embodiment, the first active area corresponds to an active area of at least one P-channel MOS transistor.

In an embodiment, the first source region is coupled to the power supply rail and/or the first drain region is coupled to a drain connection rail.

In an embodiment, the first active area corresponds to an active area of at least two P-channel MOS transistors.

In an embodiment, each cell further comprises a second transistor gate extending above the first active area between a second source region and a second drain region of said first active area, said second transistor gate being for example substantially parallel to the first insulating gate.

In an embodiment, the first and second source regions correspond to a same region coupled to the power supply rail and/or the second drain region is coupled to the drain connection rail.

In an embodiment, each cell further comprises a second active area corresponding to an active area of at least one N-channel MOS transistor, for example, two N-channel MOS transistors.

In an embodiment, the first transistor gate also extends above the second active area between a third source region and a third drain region of said second active area, and/or the second transistor gate also extends above the second active area between a fourth source region and a fourth drain region of said second active area, the third and fourth source regions for example corresponding to a same region coupled to a grounding rail.

One embodiment provides an integrated circuit comprising any of the electronic devices described above.

### Brief description of the drawings

The foregoing features and advantages, as well as others, will be described in detail in the rest of the disclosure of specific embodiments given by way of illustration and not limitation with reference to the accompanying drawings, in which:
Figure 1A shows, in a top view, a layout of an example of a transistor cell;
Figure 1B shows, in a top view, a detail of the transistor cell of Figure 1A;
Figure 2A shows, in a top view, a layout of another example of a transistor cell;
Figure 2B shows, in a top view, a detail of the transistor cell of Figure 2A;
Figure 2C shows, in a top view, a variant of a detail of the transistor cell of Figure 2A;
Figure 3A shows a layout of a transistor cell according to an embodiment;
Figure 3B shows, in a top view, a detail of a transistor cell similar to the cell of Figure 3A; and
Figure 3C shows, in a cross-section view, the transistor cell of Figure 3B.

### Description of the embodiments

Like features have been designated by like references in the various figures. In particular, the structural and/or functional features that are common among the various embodiments may have the same references and may dispose identical structural, dimensional and material properties.

For the sake of clarity, only the steps and elements that are useful for an understanding of the embodiments described herein have been illustrated and described in detail. In particular, the transistor cell manufacturing steps have not been described, being implementable with usual methods of microelectronics. Similarly, all the details of the cells and of the transistors have not been described, being within the abilities of those skilled in the art in the field of transistors. Further, the possible applications of the described transistor cells have not all been given.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless otherwise specified, when reference is made to absolute positional qualifiers, such as the terms "front", "back", "top", "bottom", "left", "right", etc., or to relative positional qualifiers, such as the terms "above", "below", "upper", "lower", etc., or to qualifiers of orientation, such as "horizontal", "vertical", etc., reference is made to the orientation shown in the figures.

In the following description, when reference is made to a "cell", it is referred unless specified otherwise to a transistor cell. Further, the cells may correspond to standard cells.

When reference is made to an "active area", it is referred to a semiconductor area of a transistor, for example, delimited by insulating regions. An active area typically comprises at least one source region, at least one drain region, and at least one channel-forming region, or channel region, between two adjacent source and drain regions. The active area may be formed in a substrate or in a well formed in a substrate.

In the following disclosure, a width corresponds to a dimension in a first direction of a main plane XY, corresponding to the Y direction indicated in the drawings. A length corresponds to a dimension in a second direction, orthogonal to the Y direction, corresponding to the X direction indicated in the drawings, of the main plane XY. The second direction is parallel to the transistor conduction direction. A channel length of a transistor substantially corresponds to the distance between a source region and a drain region of the transistor. A thickness or a depth corresponds to a dimension in the direction perpendicular to the main plane, for example, a vertical direction, corresponding to the Z direction indicated in the drawings. The term "lateral" refers to the width direction (Y direction) and the term "transversal" reference to the length direction (X direction).

Unless specified otherwise, the expressions "around", "approximately", "substantially" and "in the order of" signify within 10%, and preferably within 5%.

A cell may be manufactured in a CMOS technology, and comprise a plurality of MOS transistors. Typically, a cell may comprise at least one NMOS transistor and at least one PMOS transistor located inside and on top of an SOI-type substrate.

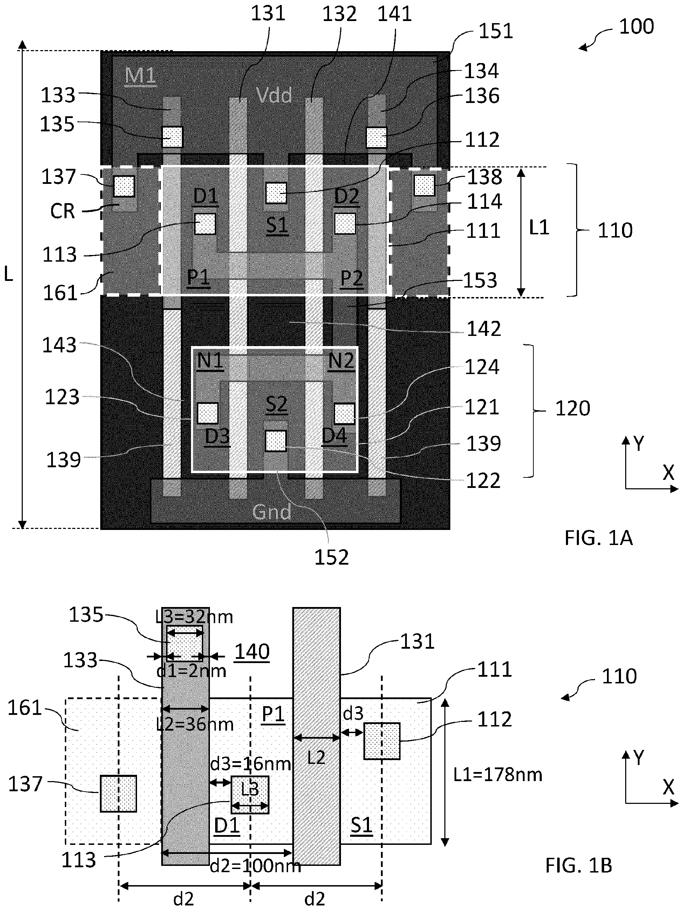

Figure 1A shows, in a top view, a layout of an example of a transistor cell 100. Figure 1B shows, in a top view, a detail of the cell 100 of Figure 1A. More precisely, Figure 1B shows a PMOS transistor of cell 100.

Cell 100 is a CMOS-type cell containing four MOS transistors: two PMOS transistors P1, P2 in a first region 110 and two NMOS transistors N1, N2 in a second region 120. A first PMOS transistor P1 has a first transistor gate 131 common with a first NMOS transistor N1, and a second PMOS transistor P2 has a second transistor gate 132 common with a second NMOS transistor N2. A first active area 111 is formed on the first region 110 where the PMOS transistors are located and a second active area 121 is formed in the second region 120 where the NMOS transistors are located. First active area 111 is of type P, and is, for example, formed in a N-type substrate or well (regular well). Second active area 121 is of type N, and is, for example, formed in a P-type substrate or well (regular well). As a variant, the first active area of type P may be formed in a P-type substrate or well (flip well) and/or the second active area of type N may be formed in a N-type substrate or well (flip well).

NMOS transistors N1, N2 for example have a silicon (Si) channel region. PMOS transistors P1, P2 for example have a strained channel region, for example, have a SiGe channel region. As a variant, PMOS transistors P1, P2 may have a Si channel region.

Active areas 111, 121 comprise source and drain regions S1, S2 and D1, D2, D3, D4 formed in the vicinity of transistor gates 131, 132.

For transistors P1, P2, source and drain regions S1 and D1, D2 are P-doped. For transistors N1, N2, source and drain regions S2 and D3, D4 are N-doped.

The source region S1 in first active area 111 is located between transistor gates 131, 132 and is common to transistors P1, P2. A source contact 112 is formed on this source region S1 to couple it to the power supply voltage (Vdd) via a first connection rail 151 (power supply rail).

The source region S2 in second active area 121 is also located between transistor gates 131, 132 and is common to transistors N1, N2. A source contact 122 is formed on this source region S2 to couple it to ground (Gnd) via a second connection rail 152 (grounding rail).

The drain region D1 of transistor P1 is located between a first gate of transistor 131 (described hereafter) and first insulating gate 133. The drain region D2 of transistor P2 is located between second transistor gate 132 and a second insulating gate 134 (described hereafter).

The drain region D3 of transistor N1 is located on the other side of the first gate of transistor 131 with respect to source region S2. The drain region D4 of transistor N2 is located on the other side of second transistor gate 132 with respect to source region S2.

A drain contact 113, 114, 123, 124 is respectively formed on each drain region D1, D2, D3, D4. A third connection rail 153 couples the drain contacts together, and couples them to form an internal connection of the cell.

In the shown example, the active area 111 of the PMOS transistors P1, P2 of cell 100 is insulated along the X direction from other active areas 161 and/or from other cells (not shown), by first and second insulating gates 133, 134, or non-active gates ("gate tie" or "tying gate"). For example, insulating gates 133, 134 are placed at the lateral limits of cell 100. An insulating gate contact 135, 136 is formed on each insulating gate to bias it to power supply voltage Vdd, via first connection rail 151, or power supply rail, so that the insulating gate can insulate active area 111. Each of the insulating gates 133, 134 is, for example, prolongated by a dummy gate 139, such as a dummy polysilicon track, on both sides of second active area 121 of NMOS transistors N1, N2.

Two other contacts 137, 138 are provided on another active area 161 on the other side of each insulating gate 133, 134, and are coupled to power supply voltage Vdd, via first connection rail 151. These other contacts represent connections from adjacent cells.

Outside of the active areas, insulating regions are formed, typically in the form of a shallow insulating trenches, of STI type. For example, a first insulating region 141 is located under first connection rail 151, a second insulating region 142 is located between the first and second active areas to insulate them from each other, and/or a third insulating region 143 is located around second active area 121.

A conductive interconnection layer, which may be designated with the term "metal 1" (M1), for first metal level, may be deposited and then shaped to form the connection rails or other traces and/or tracks (not shown), more widely interconnection circuits. For example, the conductive layer may be formed of aluminum or of its alloys, of copper or of its alloys, or of other materials such as doped polysilicon.

The manufacturing of a cell, in particular in a CMOS technology, generally has to comply with design rules, in particular in terms of positioning of the contacts, of the connection rails, in terms of distance between contacts and gates, for example to avoid risks of short-circuit and/or of leakage current and/or to limit the forming of parasitic capacitances.

In particular, each insulation gate contact 135, 136 should either respect a minimum distance limit with respect to the lateral edges of the insulating gates, to be sure that the insulating gate contact does not extend beyond the lateral edges of the insulating gate, taking into account a risk of misalignment on manufacturing, or be preferably positioned outside of the active area, to avoid any risk of short-circuit between the contacts and the active area, which may be incidentally formed during the transistor manufacturing. There has been shown in Figure 1B a distance d1 between insulating gate contact 135 and the lateral edges of insulating gate 133 under the minimum limit, for example, equal to approximately 2 nm. Thus, insulating gate contact 135 is positioned outside of active area 111, above first insulating region 141.

Each contact may have a standardized length L3, in the shown example equal to approximately 32 nm.

The design rules may also set a minimum distance between drain contact 113 or source contact 112 and the closest insulating or transistor gate. In the example, the distance d3 between drain contact 113 or source contact 112 and the closest insulating or transistor gate is equal to approximately 16 nm.

A corollary of the positioning of insulating gate contact 135 above first insulating region 141 is that, given the different design rules and constraints, and for a fixed total cell width L, the width L1 of first active area 111 cannot be extended beyond a given value, for example, approximately 178 nm in the shown example. Now, it may be desired to increase the width of the active area, in order to increase the transistor performance, particularly in terms of transistor cell performance increase standard requirements.

In the example illustrated in Figure 1B, the pitch d2 between two gates, which corresponds to a gate length L2 plus the distance between two adjacent gates, is equal to approximately 100 nm, and the length L2 of the insulating gate is equal to approximately 36 nm. The gates are shown as being arranged according to a uniform pitch, a uniform length in direction X, and extend along a single direction Y (unidirectional). The Y direction (first direction) corresponds, or is parallel, to the longitudinal direction of the gates.

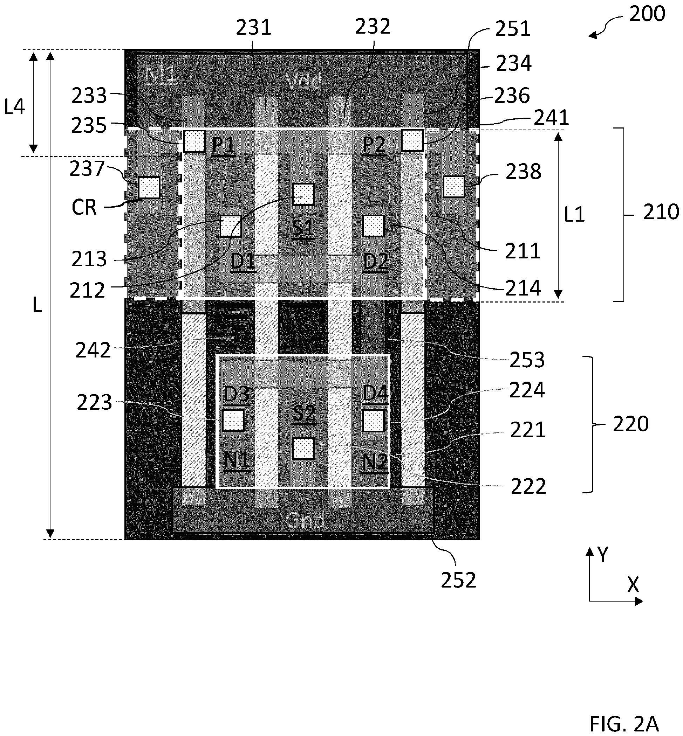

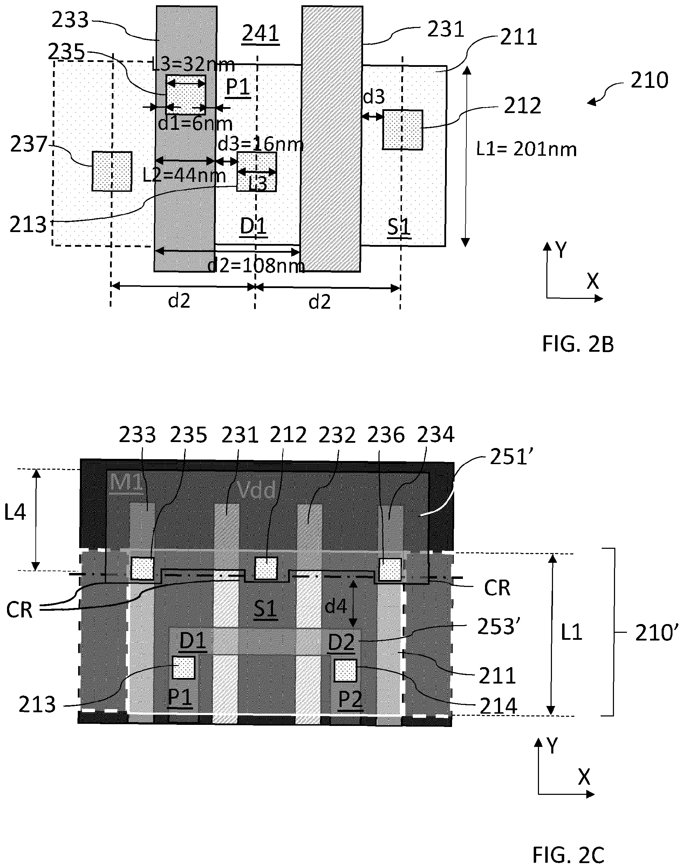

Figure 2A shows, in a top view, a layout of another example of a transistor cell 200. Figure 2B shows, in a top view, a detail of the cell 200 of Figure 2A. More precisely, Figure 2B shows a PMOS transistor of cell 200.

Similarly to the cell 100 of Figure 1A, cell 200 is a CMOS-type cell containing four MOS transistors: two PMOS transistors P1, P2 in a first region 210 and two NMOS transistors N1, N2 in a second region 220, a first PMOS transistor P1 having a first transistor gate 231 common with a first NMOS transistor N1, and a second PMOS transistor P2 having a second transistor gate 232 common with a second NMOS transistor N2. A first active area 211 is formed in the first region 210 where the PMOS transistors are located and a second active area 221 is formed in the second region 220 where the NMOS transistors are located. Second region 220 is similar to the second region 120 of Figure 1A.

Cell 200 can be distinguished from cell 100 essentially in that, as illustrated in Figure 2B, the pitch d2 between two gates is increased with respect to the pitch d2 of Figure 1B, in the example from 100 nm to 108 nm. This enables to increase the length L2 of the gates, and particularly of insulating gates 233, 234. In the example, the gate length L2 increases from 36 to 44 nm. The distance d1 between each insulating gate contact 235, 236 and said insulating gate is thus increased, in the example from 2 to 6 nm, for an equal contact length L3. This enables to avoid for an insulating gate contact 235, 236 to be misaligned with respect to an insulating gate 233, 234. Thus, each insulating gate contact 235, 236 may be positioned above active area 211, and not necessarily above an insulating region, such as first insulating region 241. Thus positioning the insulating gates enables, all dimensions being equal apart from pitch d2 and length L2 of the gates, in particular for an equal total cell width L, to increase the width L1 of first active area 211, for example from 178 nm to approximately 201 nm in the shown example.

It can be observed in Figures 1A and 2A that the first connection rail 151, 251 has in top view a rectangular shape having a transverse surface (in direction X) exhibiting jogs CR sufficiently large to couple insulating gate contacts 235, 236 and source contact 212 to power supply voltage Vdd, without connecting drain contacts 213, 214, and to ensure a minimum distance with the third connection rail 253 which couples the drain contacts.

This jogged shape being complex to manufacture, a designer may want to decrease the dimensions of these jogs, or even to suppress all or part of these jogs, for example by increasing the jog-less width L4 of the first connection rail. For example, when the pitch d2 between two gates is increased to be able to position the insulating gate contacts above the active area, it may be necessary to increase the jog-less width L4 of the first rail, for example from 132 to 160 nm to connect the gate insulating contacts and the source contact. The design rules may require for the fact of increasing this width L4 to require increasing the spacings between connection rails.

Figure 2C shows, in a top view, a variant of the cell 200 of Figure 2A, which differs therefrom essentially in that source contact 212 has been raised to be positioned substantially at the same level in the Y direction as the insulating gate contacts 235, 236. In Figure 2C, a single PMOS transistor of cell 200 is shown.

In this variant, it can be observed that first connection rail 251', enabling to couple insulating gate contacts 235, 236 and source contact 212 to power supply voltage Vdd, has a rectangular shape in top view, still with jogs, but which are less extended than in Figure 2B. It may indeed be necessary to keep jogs so that first connection rail 251' is positioned at an average distance d4 from third connection rail 253' greater than a limit defined by the design rules, for example, to avoid leakage currents and/or limit parasitic capacitances.

These examples illustrate the more general issue of increasing the dimensions of a transistor, in particular the dimensions, for example the width, of the active area of a transistor. In particular, they illustrate the issue of increasing the dimensions, for example the width, of the active area of a transistor in a transistor cell of given dimensions, for example of given width, given the design rules and constraints, in particular when it is desired to avoid adding complexity to the method of manufacturing such a cell.

The inventors provide a transistor cell enabling to address the previously-described improvement needs, and to overcome all or part of the disadvantages of the previously-described transistor cells. In particular, the inventors provide a transistor cell, for which the width of the active area of certain transistors, for example, of PMOS transistors, can be increased, in particular without having to increase dimensions of circuits of connection of these transistors, and/or without adding complexity to the method of manufacturing these transistors, for example without having to form complex shapes of connection circuits.

Embodiments of transistor cells will be described hereafter. The described embodiments are non-limiting and various variants will occur to those skilled in the art based on the indications of the present disclosure.

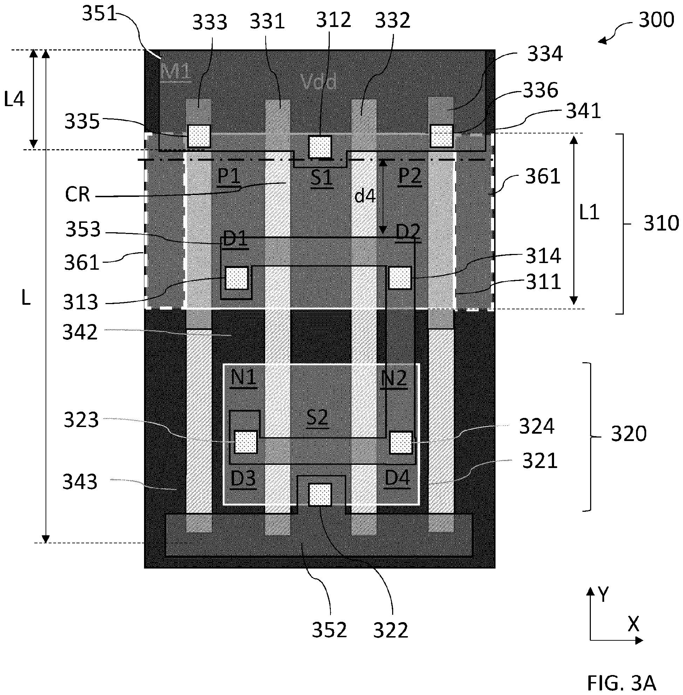

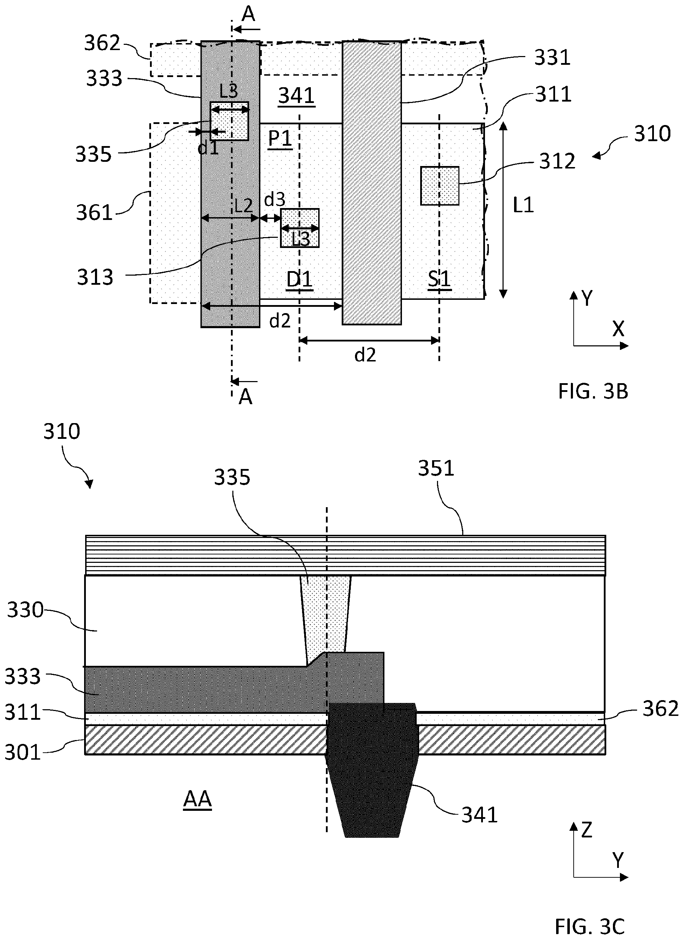

Figure 3A shows a layout of a transistor cell 300 according to an embodiment. Figure 3B shows, in a top view, a detail of a transistor cell similar to that of Figure 3A. Figure 3C shows, in a cross-section view, the transistor cell of Figure 3B.

More precisely, Figures 3B and 3C show a PMOS transistor of cell 300.

Similarly to the cells 100 and 200 of Figures 1A and 2A, cell 300 is a CMOS-type cell containing four MOS transistors: first and second PMOS transistors P1, P2 in a first region 310 and first and second NMOS transistors N1, N2 in a second region 320. First PMOS transistor P1 has a first transistor gate 331 common with first NMOS transistor N1, and second PMOS transistor P2 has a second transistor gate 332 common with second NMOS transistor N2. A first active area 311 is formed on the first region 310 where the PMOS transistors are located and a second active area 321 is formed in the second region 320 where the NMOS transistors are located. First active area 311 is of type P, and is, for example, formed in a N-type substrate or well (regular well). Second active area 321 is of type N, and is, for example, formed in a P-type substrate or well (regular well). As a variant, the first active area of type P can be formed in a P-type substrate or well (flip well) and/or the second active area of type N can be formed in a N-type substrate or well (flip well).

NMOS transistors N1, N2 for example have a Si channel region. PMOS transistors P1, P2 for example have a strained channel region, for example, have a SiGe channel region. As a variant, PMOS transistors P1, P2 may have a Si channel region.

Similarly to the cells 100 and 200 of Figures 1A and 2A, source region S1 in first active region 311 is located between transistor gates 331, 332 and is common to PMOS transistors P1, P2. A source contact 312 is formed on this source region S1 to couple it to power supply voltage Vdd via a first connection rail 351 (power supply rail) . The source region S2 in second active area 321 is also located between transistor gates 331, 332 and is common to NMOS transistors N1, N2. A source contact 322 is formed on this source region S2 to couple it to ground Gnd via a second connection rail 352 (grounding rail). The drain region D1 of transistor P1 is located between first transistor gate 331 and first insulating gate 333. The drain region D2 of transistor P2 is located between second transistor gate 332 and second insulating gate 334. The drain region D3 of transistor N1 is located on the other side of first transistor gate 331 with respect to source region S2. The drain region D4 of transistor N2 is located on the other side of second transistor gate 332 with respect to source region S2. A drain contact 313, 314, 323, 324 is formed on each drain region D1, D2, D3, D4. A third connection rail 353 (or drain connection rail) couples the drain contacts together, in order to form an internal connection of the cell.

The first active area 311, or active area of PMOS transistors P1, P2, of cell 300 is insulated along the second direction X from other active areas 361 and/or from other cells (not shown), by first and second insulating gates 333, 334. In other words, insulating gates 333, 334 form insulations of first active area 311 in the X direction. For example, each insulating gate 333, 334 is placed on a lateral side of cell 300, that is, on a side extending in the cell width direction. In other words, insulating gates 333, 334 laterally delimit first active area 311.

An insulating gate contact 335, 336 is coupled to, for example, formed on, each insulating gate to bias it to power supply voltage Vdd, via first connection rail 351 and this, so that the insulating gate can effectively insulate active area 311. In other words, each insulating gate is coupled to the power supply rail via an insulating gate contact.

For example, first active area 311 and the other active areas 361 form a continuous area in direction X, and are separated by the insulating gates.

The transistor and/or insulating gates extend above the active areas.

For example, the transistor and/or insulating gates comprise polysilicon, for example are essentially made of polysilicon.

Outside of the active areas, insulating regions are formed, for example, in the form of shallow insulating trenches, of STI type. For example, a first insulating region 341 is located under first connection rail 351, a second insulating region 342 is located between the first and second active areas to insulate them from each other, and/or a third insulating region 343 is located around second active area 321.

For example, first and second insulating regions 341, 342 form other insulations of first active area 311 in the first direction Y.

A conductive interconnection layer, or metal layer 1 (M1), may be deposited and then shaped to form the connection rails, or other traces and/or tracks (not shown), more widely interconnection circuits. The conductive interconnection layer may be formed on and/or inside of an insulating layer, for example made of mostly SiO₂. Thus, the connection rails may be formed on and/or in insulating layer 330, as shown in Figure 3C. For example, the conductive layer may be formed of aluminum or of its alloys, of copper or of its alloys, or of other materials such as doped polysilicon.

There has been shown in Figure 3C an insulating layer 301 under the active areas, for example, a buried insulating layer (BOX, for "Buried Oxide"). To avoid overloading the drawing, there has not been shown in Figure 3C the well or the substrate where each active area is formed, above insulating layer 301.

Similarly to the cell 200 of Figures 2A and 2B, the pitch d2 between two gates is equal to approximately 108 nm, and the length L2 of the gates, particularly of insulating gates 333, 334, is equal to approximately 44 nm. The distance d1 between an insulating gate contact 335, 336 and the insulating gate to which the contact is coupled is thus equal to approximately 6 nm, the insulating gate contact being centered on the insulating gate in direction X, and having a length L3 equal to approximately 32 nm. The width L1 of first active area 311 is equal to approximately 201 nm.

Cell 300 differs from the cell 200 of Figures 2A, 2B, and 2C essentially in that, as illustrated in further detail in Figures 3B and 3C, each insulating gate contact 335, 336 is intentionally positioned above and straddling, in direction Y, between first insulating region 341 and first active area 311, instead of being only above the active area. As indicated above, the Y direction (first direction), corresponds, or is parallel, to the longitudinal direction of the gates, and therefore also of the insulating gates.

In Figure 3A, each insulating gate contact 335, 336 has been shown as positioned at approximately one third of its width above first insulating region 341 and at approximately two thirds of its width above first active area 311. Other positionings are possible. For example, in Figures 3B and 3C, an insulating gate contact 335 has been shown as positioned at approximately half of its width above first insulating region 341 and at approximately the other half of its width above first active area 311. In other words, in Figures 3B and 3C, the center of gate contact 335 is arranged substantially above an intermediate area between first insulating region 341 and first active area 311.

As a variant, the centers of the insulating gate contacts may be arranged at different levels in the Y direction with respect to the intermediate area between the first insulating region and the first active area.

For example, each isolation gate contact has a first surface area positioned above the first active area and a second surface area positioned above the first isolation region, the ratio between the first surface area and the second surface area, or between the second surface area and the first surface area, being between 0.2 and 0.8, for example between 0.25 and 0.75, for example between 0.35 and 0.65. As an example, the ratio is equal to about 0.35 or about 0.65.

In Figures 3A, 3B, 3C, there have been shown all the insulating gate contacts straddling, in the Y direction, between first insulating region 341 and first active area 311. As a variant, the insulating gate contacts are not necessarily all in a straddling position between the first insulating region and the first active area.

As a variant, one or a plurality of insulating gate contacts may be in a straddling position in another direction between the first insulating region and the first active area. Further, the insulating gate contacts may further extend over other active areas.

Figure 3A illustrates that the first connection rail 351, enabling to couple insulating gate contacts 335, 336 and source contact 312 to power supply voltage Vdd, always has a rectangular shape in top view, but with fewer jogs than in Figures 2A and 2C. A single jog CR is kept to couple source contact 312, which is entirely positioned above first active area 311. As a variant, this jog may be suppressed if the distance between first rail 351 and another connection rail, such as third rail 353, is sufficient for it to be possible to increase the width of said first rail without including a jog.

Thus, the fact of positioning an insulating gate contact straddling between the first insulating region and the first active area enables to increase the width of the active area of the PMOS transistors without it being necessary to increase dimensions of connection rails, and/or to form complex shapes of the connection rails.

The embodiments may find a plurality of applications. For example, the embodiments may apply to a phase-change memory (PCM), capable of being associated with one or a plurality of transistor cells in an integrated circuit.

Various embodiments and variants have been described. Those skilled in the art will understand that certain features of these various embodiments and variants may be combined, and other variants will occur to those skilled in the art. In particular, a single transistor cell has been shown, with four transistors, two PMOS transistors and two NMOS transistors. As a variant, the cells may comprise more than four transistors or less than four transistors, with a different number of PMOS transistors and of NMOS transistors, and/or with a configuration different from that shown in the drawings and described. Further, a single cell has been shown, knowing that generally, more than two cells are included in an electronic device, or an integrated circuit.

Finally, the practical implementation of the described embodiments and variations is within the abilities of those skilled in the art based on the functional indications given hereabove.

## Claims

1. Electronic device comprising at least one cell (300) of transistors, each cell comprising:
- a first active area (311) of at least one transistor among the transistors of said cell;
- a first insulating region (341) forming a first insulation of the first active area;
- a first insulating gate (333) extending above the first active area, forming a second insulation of the first active area; and
- a first insulating gate contact (335) coupled to the first insulating gate and adapted to coupling said first insulating gate to a power supply rail (351), said first insulating gate contact being positioned above, and straddling between in a first direction (Y), the first active area and the first insulating region, the first direction (Y) being parallel to the longitudinal direction of the first insulating grid.

2. Non-transitory memory configured to store a cell library, each cell being defined so as to comprise:
- a first active area (311) of at least one transistor among transistors of said cell;
- a first insulating region (341) forming a first insulation of the first active area;
- a first insulating gate (333) extending above the first active area, forming a second insulation of the first active area; and
- a first insulating gate contact (335) coupled to the first insulating gate and adapted to coupling said first insulating gate to a power supply rail (351), said first insulating gate contact being positioned above, and straddling between, in a first direction (Y), the first active area and the first insulating region, the first direction (Y) being parallel to the longitudinal direction of the first insulating grid.

3. Device according to claim 1, or memory according to claim 2, wherein each cell further comprises:
- a second insulating gate (334) extending above the first active area, forming a third insulation of the first active area; and
- a second insulating gate contact (336) coupled to the second insulating gate and adapted to coupling said second insulating gate to the power supply rail (351), said second insulating gate contact being positioned above, and straddling between, in the first direction (Y), the first active area and the first insulating region, the second insulating gate being substantially parallel to the first insulating gate.

4. Device according to claim 1 or 3, or memory according to claim 2 or 3, wherein the first and/or the second insulating gate contact is intentionally in straddling position in the first direction (Y) between the first active area and the first insulating region.

5. Device according to any of claims 1, 3, 4, or memory according to any of claims 2 to 4, wherein the first and/or second insulating gate contact is centered in the first direction (Y) with respect to an intermediate area between the first insulating region and the first active area.

6. Device according to any of claims 1, 3 to 5, or memory according to any of claims 2 to 5, wherein the first and/or the second isolation gate contact has a first surface area positioned above the first active area and a second surface area positioned above the first isolation region, the ratio between the first surface area and the second surface area, or between the second surface area and the first surface area, being between 0.2 and 0.8, for example between 0.25 and 0.75, for example between 0.35 and 0.65.

7. Device according to any of claims 1, 3 to 6, or memory according to any of claims 2 to 6, wherein the first and/or the second insulating gate contact has a first surface area positioned above the first active area and a second surface area positioned above the first insulating region, the first surface area being greater than the second surface area.

8. Device according to any of claims 1, 3 to 7, or memory according to any of claims 2 to 7, wherein each cell further comprises a first transistor gate (331) extending above the first active area (311) between a first source region (S1) and a first drain region (D1) of said first active area, said first transistor gate being for example substantially parallel to the first insulating gate (333).

9. Device according to any of claims 1, 3 to 8, or memory according to any of claims 2 to 8, wherein the first active area (311) corresponds to an active area of at least one P-channel MOS transistor (P1).

10. Device according to claim 9 in combination with claim 8, or memory according to claim 9 in combination with claim 8, wherein the first source region (S1) is coupled to the power supply rail (351) and/or the first drain region (D1) is coupled to a drain connection rail (353).

11. Device according to any of claims 1, 3 to 10, or memory according to any of claims 2 to 10, wherein the first active area (311) corresponds to an active area of at least two P-channel MOS transistors (P1, P2).

12. Device according to claim 11, or memory according to claim 11, wherein each cell further comprises a second transistor gate (332) extending above the first active area (311) between a second source region (S1) and a second drain region (D2) of said first active area, said second transistor gate being for example substantially parallel to the first insulating gate (333).

13. Device according to claim 12, or memory according to claim 12, wherein the first and second source regions (S1) correspond to a same region coupled to the power supply rail (351) and/or the second drain region (D2) is coupled to the drain connection rail (353).

14. Device according to any of claims 1, 3 to 13, or memory according to any of claims 2 to 13, wherein each cell further comprises a second active area (321) corresponding to an active area of at least one N-channel MOS transistor (N1), for example, two N-channel MOS transistors (N1, N2).

15. Device according to claim 14 in combination with claim 8 and/or 12, or memory according to claim 14 in combination with claim 8 and/or 12, wherein the first transistor gate (331) also extends above the second active area (321) between a third source region (S2) and a third drain region (D3) of said second active area, and/or the second transistor gate (332) also extends above the second active area (321) between a fourth source region (S2) and a fourth drain region (D4) of said second active area, the third and fourth source regions for example corresponding to a same region coupled to a grounding rail (352).

16. Integrated circuit comprising an electronic device according to claim 1.
